# EUROPÄISCHE PATENTSCHRIFT

(11) **EP 1 488 520 B1**
(45) Veröffentlichungstag und Bekanntmachung des Hinweises auf die Patenterteilung: **12.08.2009**
(21) Anmeldenummer: 03744826.3
(22) Anmeldetag: 20.03.2003
(51) Int. Cl.: H03K 17/968, B60Q 1/14, G01D 5/34

(54) **VORRICHTUNG ZUM OPTOELEKTRONISCHEN ERFASSEN VON SCHALTSTELLUNGEN EINES SCHALTMITTELS**
DEVICE FOR THE OPTOELECTRONIC DETECTION OF SWITCHING POSITIONS OF A SWITCHING ELEMENT
DISPOSITIF DE DETECTION OPTOELECTRONIQUE DE POSITIONS DE COMMUTATION D'UN MOYEN DE COMMUTATION

(30) Priorität: 22.03.2002 DE 10212824
(43) Veröffentlichungstag der Anmeldung: 22.12.2004
(73) Patentinhaber: Leopold Kostal GmbH & Co. KG, 58507 Lüdenscheid (DE)
(72) Erfinder: BOEHNE, Gregor, 44575 Castrop-Rauxel (DE); PALMOWSKI, Alfred, 58093 Hagen (DE)
(86) Internationale Anmeldenummer: PCT/EP2003/002933
(87) Internationale Veröffentlichungsnummer: WO 2003/081778

(56) Entgegenhaltungen:
- EP-A- 0 913 940
- DE-A- 4 332 748
- DE-A- 4 336 729
- US-A- 5 780 795
- US-B1- 6 236 004

## Beschreibung

Die Erfindung betrifft Vorrichtung zum optoelektronischen Erfassen von Schaltstellungen eines mechanisch betätigbaren, zwangsgeführten Schaltmittels mit einem in eine Rastkurve eingreifenden Schaltstößel, umfassend zumindest einen optischen Empfänger, zumindest einen zum Belichten des zumindest einen Empfängers angeordneten optischen Sender und eine Blende, wobei die Blende und die Anordnung, bestehend aus dem zumindest einen Sender und dem zumindest einen Empfängern, relativ zueinander bewegbar sind und das bewegliche Element - Blende oder Anordnung - an die Bewegung des Schaltmittels gekoppelt ist.

Vorrichtungen zum Erfassen von Schaltstellungen werden etwa bei Schaltern verwendet, mit denen mehrere Funktionen schaltbar sind und bei denen eine Trennung zwischen einer mechanischen Haptik und einer elektrischen Schaltstellungserfassung vorgesehen ist. Derartige Schalter werden beispielsweise als Beleuchtungs- oder Lenkstockschalter in Kraftfahrzeugen eingesetzt. Damit die Vielzahl der Funktionen unabhängig voneinander und parallel zueinander ausgeführt werden können, werden solche Schalter in mehreren Richtungen bewegbar ausgestaltet. Dabei dient eine Schaltstellungserfassung dem Zweck, die jeweilige Schalterstellung direkt den geschalteten Geräten oder auch als Dateneingang einer Datenverarbeitungsanlage, etwa einem Bordcomputer bei Kraftfahrzeugen, für Überwachungs- und Steuerungszwecke zugänglich zu machen.

Weiterhin können zur Darstellung der jeweiligen Schalterstellung dem Schalter hinterleuchtete Symbole zugeordnet sein, wobei in Abhängigkeit von der jeweiligen Schalterstellung das oder die Symbole hinterleuchtet sind, die für die tatsächlich eingeschaltete Funktionen stehen.

Derartige Schalter sind herkömmlich als Kontaktschalter ausgelegt, so daß eine Schalterstellung dann erreicht ist, wenn durch das Schaltorgan die entsprechende elektrische Verbindung hergestellt ist. Auch wenn mit einem solchen Multifunktionsschalter eine Vielzahl unterschiedlicher Funktionen schaltbar sind, so erhöht sich der Aufwand bei komplizierten Schalterstrukturen unverhältnismäßig, wenn die jeweiligen Schalterstellungen auf die oben beschriebene Weise erfaßt werden sollen. Im übrigen unterliegen die für eine mechanische Kontaktierung vorgesehenen Elemente einem Verschleiß und Alterungserscheinungen.

Multifunktionsschalter können, wie aus DE 43 32 748 A1 bekannt, als kontaktlose optoelektronisch arbeitende Schalter ausgebildet sein. Der in diesem Dokument beschriebene Schalter zeichnet sich dadurch aus, daß zur Erfassung einer Schaltstellung keine elektrische Kontaktierung herbeigeführt werden muß, sondern daß ein photosensitives Element als Empfänger lichtbeaufschlagt ist, wenn sich das Schaltmittel in einer bestimmten Schaltposition befindet. Ein solcher optischer Schalter umfaßt neben dem photosensitiven Element eine Lichtquelle, die beispielsweise auf derselben Platine wie das photosensitive Element angeordnet sein kann. Mittels eines Lichtleitkörpers, dessen lichtauskoppelseitige Fläche zur photosensitiven Oberfläche des photoelektrischen Elementes weisend angeordnet ist, wird das benötigte Licht zu dem photoelektrischen Element gebracht. Zwischen der Auskoppelseite des Lichtleitkörpers und dem photoelektrischen Element ist ein Bewegungsspalt vorgesehen, in dem eine an die Bewegung des Schaltmittels gekoppelte Blende bewegbar ist. Die Blende weist an vorgegebener Position eine Durchbrechung auf, so daß nach einem Bewegen des Schaltmittels in eine bestimmte Schaltstellung die Durchbrechung mit der auskoppelseitigen Fläche des Lichtleitkörpers und der photosensitiven Oberfläche des photoelektrischen Elementes fluchtet, so daß letzteres lichtbeaufschlagbar ist. Wird das Schaltmittel aus dieser Position wieder heraus bewegt, ist das photoelektrische Element abgeschattet und die Schaltstellung verlassen. Jede Schaltstellung ist beim Gegenstand dieses Dokumentes somit durch einen eigenen optoelektronischen Schalter realisiert. Durch entsprechendes Anordnen mehrerer derartiger optischer Schalter lassen sich auch komplizierte Schaltbewegungen erfassen. Bei beengten Einbauraumverhältnissen ist es jedoch mitunter nicht möglich, komplizierte Schaltbewegungen auf die beschriebene Art und Weise zu realisieren.

Bei der Konzeption dieser vorbekannten Vorrichtung ist es notwendig, daß die Sender und Empfänger sehr genau zueinander ausgerichtet sein müssen, insbesondere wenn auch kleine Schaltschritte bestimmungsgemäß voneinander unterschieden werden sollen. Aufgrund der sich ergebenden Toleranzketten bei der Herstellung und Anordnung der Teile der Lichtschranken und der Blende kann es vorkommen, daß nach einem Einbau der Elemente, beispielsweise in das Gehäuse eines Lenkstockschalters, zum Erfassen seiner Schaltpositionen mitunter ein Empfänger in einer bestimmten Schaltposition nicht hinreichend durch einen optischen Sender angestrahlt ist, so daß unter Umständen eine ausreichende Belichtungsintensität zum Detektieren dieser Schaltstellung nicht gegeben ist.

Ausgehend von diesem diskutierten Stand der Technik liegt der Erfindung daher die Aufgabe zugrunde, eine eingangs genannte gattungsgemäße Vorrichtung zum optoelektronischen Erfassen von Schaltstellungen eines mechanisch betätigbaren Schaltmittels dergestalt weiterzubilden, daß insbesondere die beim vorbekannten Stand der Technik auftretenden Toleranznachteile reduziert, wenn nicht gar vermieden sind.

Diese Aufgabe wird erfindungsgemäß dadurch gelöst, daß ein Teil der Schaltsiellungserfassungseinrichtung - der zumindest eine Sender oder der zumindest eine Empfänger - aus Blickrichtung des jeweils komplementären Teils der Schaltstellungserfassungseinrichtung - Empfänger bzw. Sender - hinter einem Abschnitt als Teil des die Rastkurve ausbildenden, lichtundurchlässigen Elementes angeordnet ist und daß in den Abschnitt des die Rastkurve ausbildenden, lichtundurchlässigen Elementes zu dem anderen Teil der Schaltstellungserfassungseinrichtung - Empfänger bzw. Sender - hin offene oder hinreichend transparente Lichtstrahlöffnungen an einzelne Schaltpunkte der Rastkurve definierenden Positionen eingebracht sind.

Diese zumindest eine Lichtstrahlöffnung ist als Teil des die Rastkurve ausbildenden Elementes vorteilhaft möglichst einstückig mit der Rastkurve, beispielsweise im Wege eines Spritzgußverfahrens hergestellt. Die zumindest eine Lichtstrahlöffnung ist an den den mechanischen Schaltpunkten entsprechenden Positionen, beispielsweise in einen sich von der eigentlichen Rastkurve abragenden Flansch eingebracht. Hinter den überlicherweise mehreren Lichtstrahlöffnungen aus Blickrichtung des Empfängers bzw. des optischen Senders befinden sich die Lichtquellen, beispielsweise LED's bzw. die optischen Empfänger. Die Lichtstrahlöffnungen sind bezüglich ihrer lichten Weite so bemessen, daß Toleranzen, resultierend aus der Einbauanordnung der hinter der Lichtstrahlöffnung befindlichen Elemente - Empfänger oder Sender - ohne weiteres kompensiert sind. Bei einer Anordnung der optischen Sender hinter der Lichtstrahlöffnung ist beispielsweise vorgesehen, die durch die Lichtstrahlöffnungen bereitgestellten Blendenöffnungen kleiner zu konzipieren als die in die Ebene des Empfängers projizierte lichtemittierende Fläche eines solchen optischen Senders. Dadurch ist sichergestellt, daß auch bei einer Anordnung der optischen Sender im Rahmen einer gewissen Toleranz hinter den Lichtstrahlöffnungen immer noch eine bestimmungsgemäße Belichtung des optischen Empfängers möglich ist. Durch die Lichtstrahlöffnungen bzw. die die Lichtstrahlöffnung bildenden Bereiche des Rastkurventeils werden zusätzlich Streustrahlungen reduziert.

Die Elemente der optischen Schalteranordnungen sind zweckmäßigerweise auf einer gemeinsamen flexiblen Leiterplatte angeordnet, die zur Ausbildung der gewünschten optischen Schalteranordnungen in den Abschnitten, in denen die Sender bzw. Empfänger angeordnet sind, zueinander weisend aufgestellt und jeweils an einem entsprechenden Widerlager fixiert sind.

In einer besonders vorteilhaften Ausgestaltung ist vorgesehen, entweder nur einen Empfänger und mehrere optische Sender, oder nur einen Sender und mehrere optische Empfänger zur Ausbildung der Lichtstrahlanordnung vorzusehen. Dabei sind zumindest zwei Empfänger bzw. zwei Sender in Schaltrichtung des Schaltmittels jeweils mindestens einen Schaltschritt entsprechend voneinander beabstandet angeordnet. Die Blende weist einen Abschattungsbereich auf, durch den bei einem Wechsel der Schaltstellungen zu einer benachbarten Schaltstellung des Schaltmittels sich jeweils nur der Zustand eines einzigen Empfängers bzw. nur eine einzige Lichtquelle ihren Zustand im Hinblick auf eine Belichtung des Empfängers ändert. Bei einer solchen Ausgestaltung ist es, am Beispiel eine Anordnung besteht aus einem Sender und zwei Empfängern, möglich, grundsätzlich vier Schaltschritte zu detektieren, da auch ein Zustand, in dem beide Empfänger abgeschattet sind, als Schaltstellung definierbar ist. Aus diesem Grunde weist die Blende einen Abschattungsbereich auf, mit dem gegebenenfalls beide Empfänger gleichzeitig abschattbar sind. Somit sind bei einer solchen Ausgestaltung, wenn eine Teilabschattung einzelner Empfänger nicht vorgesehen ist, lediglich zwei Empfänger notwendig, so daß die Zahl der eingesetzten Empfänger gegenüber der beim vorbekannten Stand der Technik notwendigen Empfängeranzahl um 50% reduziert ist.

Bei Vorsehen einer Teilabschattung kann sich die Zahl der benötigten Empfänger gegenüber dem vorbekannten Stand der Technik noch weiter reduzieren. Zur Vermeidung von Fehlinterpretationen ist beim Gegenstand der beanspruchten Schaltstellungserfassungsvorrichtung ferner vorgesehen, daß bei einem Wechsel der Schaltstellung zu einer benachbarten Schaltstellung des Schaltmittels jeweils nur ein einziger Empfänger seinen Zustand ändert. Diese Zustandsänderung kann hervorgerufen sein durch Belichten eines zuvor unbelichteten Empfängers oder umgekehrt, oder auch durch Ändern der Belichtungsintensität, beispielsweise durch eine bereichsweise Abschattung eines Empfängers durch die Blende.

Ohne weiteres eignet sich eine solche Schaltstellungserfassungsvorrichtung auch dazu, eine Schaltstellungserfassung durchzuführen, wenn das Schaltmittel in zwei oder mehr Richtungen bewegbar ist. In jeder Bewegungsrichtung des Schaltmittels ist eine aus zumindest zwei Empfängern bestehende Empfängeranordnung und die Blende mit ihrem Abschattungsbereich - beides wie oben beschrieben - konzipiert. Durch den verglichen mit dem vorbekannten Stand der Technik geringeren Hardwareeinsatz lassen sich mit einer solchen Schaltstellungserfassungsvorrichtung auch komplizierte Schaltbewegungen optoelektronisch detektieren, ohne daß dazu ein größerer Einbauraum notwendig wäre.

Zum Auswerten dieser Schaltstellungserfassungsvorrichtung ist der Einsatz eines Mikroprozessors grundsätzlich nicht notwendig. Die Auswertung kann über eine Digitalschaltung erfolgen, über die das Ausgangssignal unmittelbar an eine das Ausgangssignal der Schaltstellungserfassungsvorrichtung weiter verarbeitenden Einrichtung zugeführt wird. Beispielsweise kann eine solche digitale Schaltung ein Binärdekodierer sein.

Eine solche Ausgestaltung der beanspruchten Vorrichtung zeigt. daß auch eine Vielzahl unterschiedlicher Schaltstellungen mit einem gegenüber dem vorbekannten Stand der Technik geringeren Hardware-Einsatz möglich ist.

Nachfolgend ist die Erfindung anhand eines Ausführungsbeispiels unter Bezugnahme auf die beigefügten Figuren beschrieben. Es zeigen:
- **Fig. 1**: eine schematisierte dreidimensionale Einsicht in das Gehäuse eines Lenkstockschalters mit einem in einer Rastkurve geführten Schaltstößel und einer Vorrichtung zum optoelektronischen Erfassen der Schaltstellungen,
- **Fig. 2**: einen Längsschnitt durch das Gehäuse der Figur 1 und
- **Fig. 3**: einen Horizontalschnitt durch das Gehäuse der Figur 1.

Ein im übrigen nicht näher dargestellter Lenkstockschalter für ein Kraftfahrzeug ist zwangsgeführt gelagert in einem Gehäuse 1, das Teil eines Lenksäulenmoduls ist. In dem Gehäuse 1 angeordnet ist eine Rastkurve 2, in die ein Schaltstößel 3 federbelastet eingreift und in der Rastkurve geführt ist. Die Rastkurve 2 dient mit dem darin eingreifenden Schaltstößel 3 zur Erzeugung der gewünschten Haptik. In der Rastkurve 3 sind die einzelnen Schaltstellungen haptisch spürbar konzipiert.

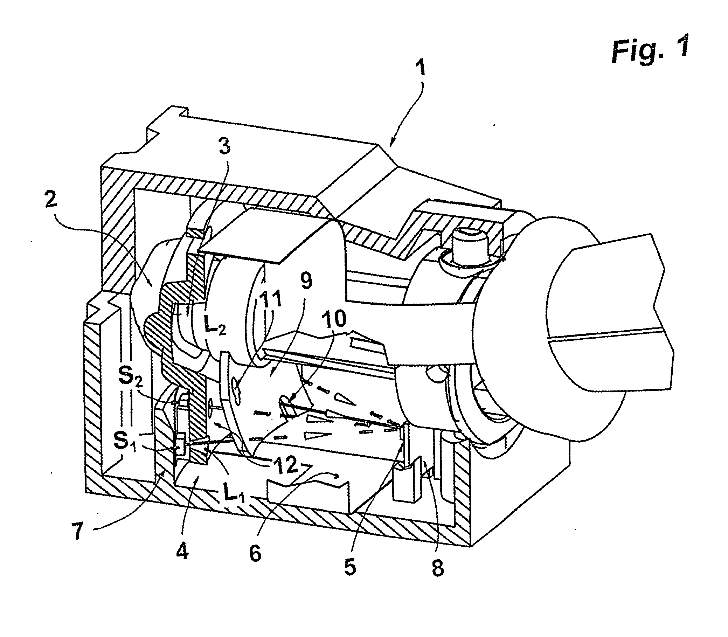

Zum elektrischen Erfassen der einzelnen Schaltstellungen des Schaltstößels 3 innerhalb der Rastkurve 2 dient eine insgesamt mit dem Bezugszeichen 4 gekennzeichnete Schaltstellungserfassungseinrichtung. Die Schaltstellungserfassungseinrichtung 4 ist optoelektronisch arbeitend ausgelegt und umfaßt einen optischen Empfänger 5 und mehrere optische Sender S₁ - S₄, von denen in Figur 1 lediglich die Sender S₁ und S₂ erkennbar sind. Bei den optischen Sendern S₁ - S₄ handelt es sich um LED's, die jeweils nacheinander Lichtstrahlen emittieren. Der als Photodiode ausgebildete optoelektronische Empfänger 5 und die optischen Sender S₁ - S₄ sind gemeinsam auf einer flexiblen Leiterplatte 6 angeordnet. Zum Ausbilden der gewünschten Lichtschrankenanordnung zwischen den optischen Sendern S₁ - S₄ und dem optischen Empfänger 5 sind Widerlager 7, 8 an dem Gehäuse 1 angeformt, an denen die Leiterbahnabschnitte befestigt sind, auf denen der optische Empfänger 5 bzw. die optischen Sender S₁ .- S₄ angeordnet sind.

Teil der Schaltstößels 3 ist eine Blende 9, die entsprechend der Bewegung des Schaltstößels 3 in der Rastkurve 2 mitbewegt wird. Die Blende 9 umfaßt bei dem dargestellten Ausführungsbeispiel zwei Blendenöffnungen 10, 11. Je nach Stellung des Schaltstößels 3 und somit auch der Blende 9 werden alle oder auch einzelne Sender S₁ - S₄ abgeschattet, während das Licht der übrigen Sender S₁ - S₄ durch die Blendenöffnungen 10, 11 oder auch am Rand der Blende 9 vorbei zum Empfänger 5 gelangen kann. Bei einer Änderung der Schaltstellung kann entweder ein weiterer Lichtweg von einem der Sender S₁ - S₄ zum Empfänger 5 geöffnet werden oder ein bereits geöffneter Lichtweg abgeschattet werden. In der in Figur 1 dargestellten Schaltstellung ist der optische Empfänger 5 durch den optischen Sender S₃ belichtet, da die Blendenöffnung 10 der Blende 9 den diesbezüglichen Strahlengang nicht behindert. Dagegen ist der optische Empfänger 5 durch die Blende 9 gegenüber einer Belichtung durch die optischen Sender S₁, S₂ und S₄ abgeschattet.

Teil der Rastkurve 2, die als Kunststoffspritzgußteil ausgebildet ist, ist ein Flansch 12, in den vier Lichtstrahlöffnungen L₁ - L₄ eingebracht sind. Die Lichtstrahlöffnungen L₁ - L₄ sind konisch ausgebildet, wobei der Verjüngung von dem optischen Empfänger (5) wegweisend verläuft. Unmittelbar hinter dem Flansch 12 befindet sich das Widerlager 7 und der an dem Widerlager 7 gehaltene Abschnitt der flexiblen Leiterplatte 6, auf dem die optischen Sender S₁ - S₄ angeordnet sind. Somit befinden sich die optischen Sender S₁ - S₄ unmittelbar hinter den Lichtstrahlöffnungen L₁ - L₄, gesehen aus Blickrichtung des optischen Empfängers 5. Jedem Sender S₁ - S₄ ist eine eigene Lichtstrahlöffnung L₁ - L₄ zugeordnet. Die lichte Weite im verjüngten Abschnitt jeder Lichtstrahlöffnung L₁ - L₄ ist geringer als die lichtemittierende Fläche der jeweiligen LED, projiziert in die Ebene des optischen Empfängers. Somit wirken die Lichtstrahlöffnungen L₁ - L₄ quasi als Blende, wodurch zum einen Streustrahlungen verhindert und insbesondere jedoch eine bestimmungsgemäße Lichtstrahlorientierung jedes optischen Senders S₁ - S₄, gerichtet zu dem optischen Empfänger 5, möglich ist, auch wenn die einzelnen optischen Sender S₁ - S₄ mit bestimmten Toleranzen hinter den Lichtstrahlöffnungen L₁ - L₄ angeordnet sind. Somit ist eine bestimmungsgemäße Anordnung der emittierten Lichtstrahlen von der Toleranz der Anordnung der Lichtstrahlöffnungen L₁ - L₄ abhängig. Diese sind jedoch vernachlässigbar, da die Lichtstrahlöffnungen L₁ - L₄ bzw. der Flansch 12 mit den Lichtstrahlöffnungen L₁ - L₄ Teil der Rastkurve 2 sind.

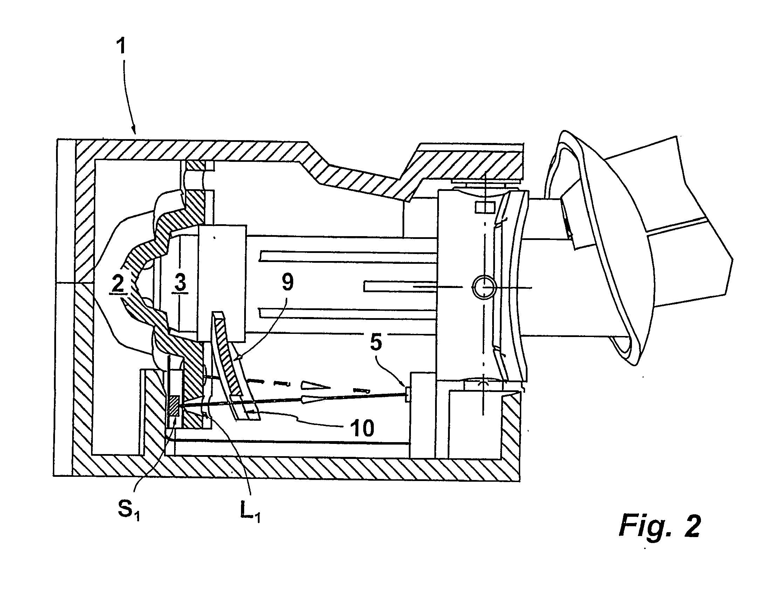

Figur 2 zeigt das Gehäuse 1 des Lenkstockschalters in einem Längsschnitt. Aus dieser Anordnung wird deutlich, daß die optischen Sender auch in unterschiedlicher Höhe bezüglich des Empfängers 5 angeordnet sein können.

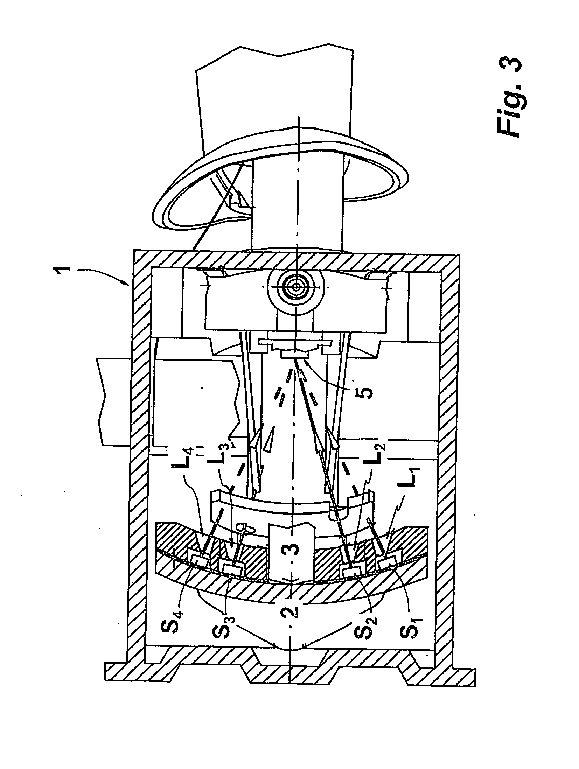

Figur 3 zeigt die Anordnung der Sender S₁ - S₄, die an dem gekrümmt ausgebildeten Widerlager anliegen. Ferner wird deutlich, daß der Flansch 12 der Rastkurve 2 Aussparungen zur Aufnahme jeweils eines optischen Senders S₁ - S₄ aufweist, so daß jeder optische Sender S₁ - S₄ quasi gekapselt angeordnet ist und ein Lichtaustritt nur durch die Lichtstrahlöffnungen L₁ - L₄ möglich ist. Dieses dient insbesondere zur Vermeidung von Streustrahlungen.

Die Erfassung unterschiedlicher Schaltstellungen ist im folgenden anhand eines Ausführungsbeispiels, bei dem ein Sender und mehrere Empfänger vorgesehen sind, beschrieben. Die Empfänger sind aus Blickrichtung des Empfängers hinter den Lichtstrahlöffnungen als Teil der Rastkurve angeordnet.

Das Schaltmittel der Schaltstellungserfassungsvorrichtung ist um zwei Drehachsen schwenkbar gelagert. An die Bewegung des Schaltmittels gekoppelt ist eine Blende, aufgebaut bei dem dargestellten Ausführungsbeispiel aus einem Halter, der einen waagerechten und einen senkrechten Abschattungsstreifen trägt. Jeder Abschattungsbereich dient zur Schaltstellungserfassung jeweils einer Empfängeranordnung. Eine aus den Empfängern E₁ und E₂ aufgebaute Empfängeranordnung mit dem aus der Position des Senders gesehen davor liegenden waagerechten Abschattungsstreifen dient zur Schaltstellungserfassung einer Bewegung des Schaltmittels in y-Richtung. Die weitere Empfängeranordnung, aufgebaut aus den Empfängern E₃ - E₅ mit dem aus der Position des Senders gesehen davor liegenden senkrechten Abschattungsstreifen dient zum Erfassen einer Schaltstellung des Schaltmittels in x-Richtung. Die Empfänger E₁, E₂ bzw. E₃ - E₅ sind jeweils einen Schaltschritt entsprechend voneinander beabstandet. Die Höhe des waagerechten Abschattungsstreifens entspricht zwei senkrechten Schaltschritten, die Breite des senkrechten Abschattungsstreifens entspricht drei waagerechten Schaltschritten. In y-Richtung sind durch den Einsatz von zwei Empfängern E₁, E₂ vier Schaltstellungen erfaßbar. In x-Richtung durch den Einsatz von drei Empfängern E₃ - E₅ sind bei diesem Ausführungsbeispiel sechs Schaltstellungen erfaßbar. Die Zustände der einzelnen Empfänger E₁ - E₅ in den unterschiedlichen Schaltstellungen der Schaltstellungserfassungsvorrichtung sind in der nachfolgenden Tabelle wiedergegeben:

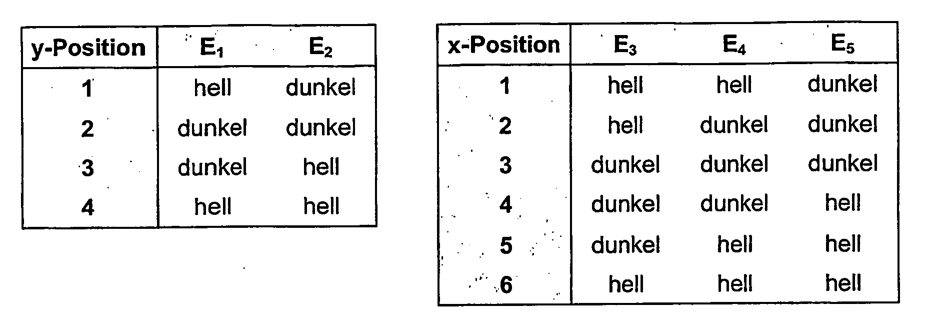

### Bezugszeichenliste

- 1: Gehäuse
- 2: Rastkurve
- 3: Schaltstößel
- 4: Schaltstellungserfassungsvorrichtung
- 5: optischer Empfänger
- 6: flexible Leiterplatte
- 7: Widerlager
- 8: Widerlager
- 9: Blende
- 10: Blendenöffnung
- 11: Blendenöffnung
- 12: Flansch

- L₁ - L₄: Lichtstrahlöffnung
- S₁ - S₄: Sender

## Patentansprüche

1. Vorrichtung zum optoelektronischen Erfassen von Schaltstellungen eines mechanisch betätigbaren, zwangsgeführten Schaltmittels mit einem in eine Rastkurve (2) eingreifenden Schaltstößel (3), umfassend zumindest einen optischen Empfänger (5), zumindest einen zum Belichten des zumindest einen Empfängers (5) angeordneten optischen Sender (S₁ - S₄) und eine Blende (9), wobei die Blende (9) und die Anordnung, bestehend aus dem zumindest einen Sender (S₁ -S₄) und dem zumindest einen Empfänger (5), relativ zueinander bewegbar sind und das bewegliche Element - Blende (9) oder Anordnung - an die Bewegung des Schaltmittels (3) gekoppelt ist, **dadurch gekennzeichnet, daß** ein Teil der Schaltstellungserfassungseinrichtung - der zumindest eine Sender oder der zumindest eine Empfänger - aus Blickrichtung des jeweils komplementären Teils der Schaltstellungserfassungseinrichtung - Empfänger bzw. Sender - hinter einem Abschnitt als Teil des die Rastkurve ausbildenden Elementes angeordnet sind und daß in den Abschnitt des die Rastkurve ausbildenden Elementes zu dem anderen Teil der Schaltstellungserfassungseinrichtung - Empfänger bzw. Sender (S₁ - S₄) - hin offene Lichtstrahlöffnungen (L₁ - L₄) an einzelne Schaltpunkte der Rastkurve (2) definierenden Positionen eingebracht sind.

2. Vorrichtung nach Anspruch 1, **dadurch gekennzeichnet, dass** ein optoelektronischer Empfänger (5) und mehrere zum Belichten des Empfängers (5) angeordnete optische Sender (S₁ -S₄) vorgesehen sind, wobei aus Blickrichtung des Empfängers (5) hinter den Lichtstrahlöffnungen (S₁ - S₄) jeweils ein Sender angeordnet ist.

3. Vorrichtung nach Anspruch 2, **dadurch gekennzeichnet, daß** die lichte Weite der durch die Lichtstrahlöffnungen (L₁ - L₄) bereitgestellten Blenden kleiner ist als die in die Ebene des Empfängers (5) projizierte lichtemittierende Fläche des hinter einer Lichtstrahlöffnung angeordneten optischen Senders (S₁ - S₄).

4. Vorrichtung nach Anspruch 2 oder 3, **dadurch gekennzeichnet, daß** der Empfänger (5) und die optischen Sender (S₁ - S₄) auf einer gemeinsamen flexiblen Leiterplatte (6) angeordnet sind.

5. Vorrichtung nach Anspruch 1, **dadurch gekennzeichnet, dass** mehrere optische Empfänger und ein zum Belichten der Empfänger angeordneter optischer Sender vorgesehen sind, wobei aus Blickrichtung des Senders hinter den Lichtstrahlöffnungen jeweils ein Empfänger angeordnet ist.

6. Vorrichtung nach Anspruch 5, **dadurch gekennzeichnet, daß** die lichte Weite der durch die Lichtstrahlöffnungen bereitgestellten Blenden in etwa der in die Ebene des Senders projizierte Fläche der hinter der Lichtstrahlöffnung angeordneten Empfänger ist.

7. Vorrichtung nach Anspruch 5 oder 6, **dadurch gekennzeichnet, daß** der optische Sender und die Empfänger auf einer gemeinsamen flexiblen Leiterplatte angeordnet sind.

8. Vorrichtung nach einem der Ansprüche 1 bis 6, **dadurch gekennzeichnet, daß** die Lichtstrahlöffnungen (L₁ - L₄) in einem an der Rastkurve (2) angeformten Flansch (12) eingebracht sind.

9. Vorrichtung nach einem der Ansprüche 1 bis 8, **dadurch gekennzeichnet, daß** die Rastkurve (2) mit den Lichtstrahlöffnungen (L₁ - L₄) ein Kunststoffspritzgußteil ist.

10. Vorrichtung nach einem der Ansprüche 1 bis 9, **dadurch gekennzeichnet, daß** diese eingebaut ist in das Gehäuse eines Lenkstockschalters für ein Kraftfahrzeug.

11. Vorrichtung nach einem der Ansprüche 2 bis 4, **dadurch gekennzeichnet, daß** zumindest zwei Lichtquellen (S₁ - S₄) in Schaltrichtung des Schaltmittels (3) jeweils mindestens einen Schaltschritt entsprechend voneinander beabstandet angeordnet sind und wobei die Blende (9) einen Abschattungsbereich aufweist, durch den bei einem Wechsel der Schaltstellung zu einer benachbarten Schaltstellung des Schaltmittels jeweils nur eine einzige Lichtquelle (S₁ - S₄) ihren Zustand im Hinblick auf eine Belichtung des Empfängers (5) ändert.

12. Vorrichtung nach einem der Ansprüche 5 bis 7, **dadurch gekennzeichnet, daß** zumindest zwei Empfänger in Schaltrichtung des Schaltmittels jeweils mindestens einen Schaltschritt entsprechend voneinander beabstandet angeordnet sind und daß die Blende einen Abschattungsbereich aufweist, durch den bei einem Wechsel der Schaltstellung zu einer benachbarten Schaltstellung des Schaltmittels sich jeweils nur der Zustand eines einzigen Empfängers ändert.

13. Vorrichtung nach einem der Ansprüche 1 bis 12, **dadurch gekennzeichnet, daß** das Schaltmittel in zwei oder mehr Richtungen bewegbar ist und in diesen Richtungen jeweils eine zur Realisierung der Schaltstellungen vorgesehene Empfängeranordnung bzw. Lichtquellenanordnung aufweist und und der Abschattungsbereich der Blende entsprechend konzipiert ist.

14. Vorrichtung nach einem der Ansprüche 1 bis 13, **dadurch gekennzeichnet, daß** das Schaltmittel um eine oder mehr Achsen drehbar gelagert ist, sich die Lichtquelle bzw. der Empfänger im Bereich des Schnittpunktes der Drehachsen befindet und die Blende eine gekrümmte Oberfläche zumindest im Abschattungsbereich mit ihrem Krümmungsmittelpunkt in dem Schnittpunkt der Drehachsen aufweist.

15. Vorrichtung nach einem der Ansprüche 1 bis 14, **dadurch gekennzeichnet, daß** als Lichtquelle oder als Lichtquellen IR-Licht emittierende Lichtquellen eingesetzt ist und der bzw. die Empfänger IRempfindlich sind und einen IR-Licht durchlassendes Filter umfassen.

16. Vorrichtung nach einem der Ansprüche 1 bis 15, **dadurch gekennzeichnet, daß** jeder Empfängeranordnung eine Binärdekodierschaltung zur unmittelbaren Erzeugung eines digitalen Ausgangssignales zugeordnet ist.

17. Vorrichtung nach einem der Ansprüche 1 bis 16, **dadurch gekennzeichnet, daß** als Empfänger ein aus einer Vielzahl von einzelnen photoelektrischen Empfängern aufgebautes Sensorarray, etwa ein Kamerasensor eingesetzt ist.

## Claims

1. Facility for the optoelectronic detection of switch positions on a mechanically operable, positively driven switching device having a switch plunger (3) that engages in a latching curve (2), comprising at least one optical receiver (5), at least one optical transmitter (S₁ - S₄) located so as to expose the at least one receiver (5), and an aperture (9), for which purpose the aperture (9) and the arrangement, consisting of the at least one transmitter (S₁ - S₄) and the at least one receiver (5), are moveable in relation to each other and the moveable element - aperture (9) or arrangement - is coupled to the movement of the switching device (3), **characterised by the fact** that one member of the facility for detecting the switch position - the at least one transmitter or the at least one receiver - is located behind a section as part of the element constituting the latching curve when viewed from the direction of the respective complementary member of the facility for detecting the switch position - receiver or transmitter, as a case may be, and that light beam openings (L₁ - L₄) that are open towards the other member of the facility for detecting the switch position - receiver or transmitter (S₁ - S₄) as the case may be - are incorporated in the section of the element constituting the latching curve at positions defining individual switch positions of the latching curve (2).

2. Facility in accordance with Claim 1, **characterised by the fact** that an optoelectronic receiver (5) and several optical transmitters (S₁ - S₄) arranged so as to expose the receiver (5) are provided, with a transmitter located behind each light beam opening (S₁ - S₄) when viewed from the direction of the receiver (5).

3. Facility in accordance with Claim 2, **characterised by the fact** that the clearance width of the apertures provided by the light beam openings (L₁ - L₄) is smaller than the light-emitting area of the optical transmitter (S₁ - S₄) located behind a light beam opening projected into the plane of the receiver (5).

4. Facility in accordance with Claim 2 or Claim 3, **characterised by the fact** that the receiver (5) and the optical transmitters (S₁ - S₄) are arranged on a common flexible printed circuit board.

5. Facility in accordance with Claim 1, **characterised by the fact** that several optical receivers and an optical transmitter located so as to expose the receiver are provided, with a receiver located behind each of the light beam openings when viewed from the direction of the transmitter.

6. Facility in accordance with Claim 5, **characterised by the fact** that the clearance width of the apertures provided by the light beam openings is roughly the area of the receiver located behind the light beam opening that is projected in the plane of the transmitter.

7. Facility in accordance with Claim 5 or Claim 6, **characterised by the fact** that the optical transmitter and the receivers are arranged on a common flexible printed circuit board.

8. Facility in accordance with any of Claims 1 to 6, **characterised by the fact** that the light beam openings (L₁ - L₄) are incorporated in a flange (12) moulded onto the latching curve (2).

9. Facility in accordance with any of Claims 1 to 8, **characterised by the fact** that the latching curve (2) with the light beam openings (L₁ - L₄) is a plastic injection-moulded component.

10. Facility in accordance with any of Claims 1 to 9, **characterised by the fact** that it is installed in the housing of a steering column switch for a motor vehicle.

11. Facility in accordance with any of Claims 2 to 4, **characterised by the fact** that at least two light sources (S₁ - S₄) are arranged in the switching direction of the switching device (3) at a distance from each other corresponding to at least one switching step, and with the aperture (9) featuring a shading area through which only a single light source (S₁ - S₄) alters its state at any one time as regards an exposure of the receiver (5) when the switching position changes to an adjacent switching position of the switching device.

12. Facility in accordance with any of Claims 5 to 7, **characterised by the fact** that at least two receivers are located in the switching direction of the switching device at a distance from each other corresponding to at least one switching step, and that the aperture (9) features a shading area through which only the state of a single receiver changes at any one time when the switching position changes to an adjacent switching position of the switching device.

13. Facility in accordance with any of Claims 1 to 12, **characterised by the fact** that the switching device is moveable in two or more directions and features a receiver arrangement or light source arrangement provided for implementing the switching positions and the shading area of the aperture is conceived accordingly.

14. Facility in accordance with any of Claims 1 to 13, **characterised by the fact** that the switching device is rotatably supported around one or more axes, the light source or the receiver is located in the vicinity of the intersection of the rotary axes, and the aperture features a curved surface at least in the shading area, with the centre point of its curve at the intersection of the rotary axes.

15. Facility in accordance with any of Claims 1 to 14, **characterised by the fact** that light sources that emit IR light are utilised as the light source or sources, and the receiver or receivers are IR-sensitive and encompass a filter that allows IR light to pass through.

16. Facility in accordance with any of Claims 1 to 15, **characterised by the fact** that a binary decoder circuit is allocated to each receiver arrangement for the direct generation of a digital output signal.

17. Facility in accordance with any of Claims 1 to 16, **characterised by the fact** that a sensor array, for instance a camera sensor, configured from a plurality of individual photoelectrical receivers, is utilised as a receiver.

## Revendications

1. Dispositif pour la saisie optoélectronique de positions de commutation d'un moyen de commutation à commande forcée, actionnable mécaniquement, avec un poussoir de commutation (3) s'engageant dans une courbe d'indexage (2), comprenant au moins un récepteur (5) optique, au moins un émetteur (S₁ - S₄) optique, agencé pour éclairer le récepteur (5) au moins prévu, et un diaphragme (9), ledit diaphragme (9) et le circuit comprenant l'émetteur (S₁ - S₄) au moins prévu et le récepteur (5) au moins prévu pouvant être déplacés l'un par rapport à l'autre, et l'élément mobile - diaphragme (9) ou circuit - étant couplé au mouvement du moyen de commutation (3), **caractérisé en ce qu'**une partie du système de saisie de positions de commutation - l'émetteur au moins prévu ou le récepteur au moins prévu - est disposée, à partir de la direction de visée de la partie complémentaire respective du système de saisie de positions de commutation - récepteur, respectivement émetteur -, derrière une section faisant partie de l'élément formant la courbe d'indexage, et que, dans la section dudit élément formant la courbe d'indexage, vers l'autre partie du système de saisie de positions de commutation - récepteur, respectivement émetteur (S₁ - S₄)-, sont prévues, à des points de commutation individuels de la courbe d'indexation (2), des positions, qui définissent des ouvertures pour le rayonnement lumineux (L₁ - L₄).

2. Dispositif selon la revendication 1, **caractérisé en ce que** sont prévus un récepteur (5) optoélectronique et plusieurs émetteurs (S₁ - S₄) , disposés pour éclairer le récepteur (5), un émetteur étant disposé, à partir de la direction de visée du récepteur (5), derrière chacune des ouvertures pour le rayonnement lumineux (L₁ - L₄).

3. Dispositif selon la revendication 2, **caractérisé en ce que** le diamètre intérieur de l'ouverture de diaphragme fournie par les ouvertures pour le rayonnement lumineux (L₁ - L₄) est inférieur à la surface émettrice de l'émetteur (S₁ - S₄) optique disposé derrière une ouverture pour le rayonnement lumineux, qui est projetée dans le plan du récepteur (5).

4. Dispositif selon la revendication 2, **caractérisé en ce que** le récepteur (5) et les émetteurs optiques (S₁ - S₄) sont disposés sur une plaquette de circuits imprimés (6) flexible, commune.

5. Dispositif selon la revendication 1, **caractérisé en ce que** sont prévus plusieurs récepteurs optiques et un émetteur, disposé pour éclairer lesdits récepteurs, un récepteur étant disposé, à partir de la direction de visée, derrière l'une des ouvertures pour le rayonnement lumineux.

6. Dispositif selon la revendication 5, **caractérisé en ce** le diamètre intérieur de l'ouverture de diaphragme fournie par les ouvertures pour le rayonnement lumineux correspond approximativement à la surface des récepteurs, disposés derrière lesdites ouvertures pour le rayonnement lumineux, qui est projetée dans le plan de l'émetteur.

7. Dispositif selon revendication 5 ou 6, **caractérisé en ce que** l'émetteur optique et les récepteurs sont disposés sur une plaquette de circuits imprimés flexible, commune.

8. Dispositif selon l'une des revendications 1 à 6, **caractérisé en ce que**.les ouvertures pour le rayonnement lumineux (L₁ - L₄) sont pratiquées dans une bride (12), formée sur la courbe d'indexation (2).

9. Dispositif selon l'une des revendications 1 à 8, **caractérisé en ce que** la courbe d'indexation (2), avec les ouvertures pour le rayonnement lumineux (L₁ - L₄), est une pièce en matière plastique, moulée par injection.

10. Dispositif selon l'une des revendications 1 à 9, **caractérisé en ce que** celui-ci est intégré dans le boîtier d'un commutateur, qui est fixé à la colonne de direction d'un véhicule automobile.

11. Dispositif selon l'une des revendications 2 à 4, **caractérisé en ce que** deux sources lumineuses (S₁ - S₄), au moins, sont disposées dans la direction de commutation du moyen de commutation (3), en étant espacées l'une de l'autre d'une distance, qui correspond au moins à un pas de commutation, et le diaphragme (9) présentant une zone d'ombre, en raison de laquelle, lors d'un passage du moyen de commutation d'une position de commutation à une position de commutation voisine, une seule source lumineuse (S₁ - S₄) modifie sont état en ce qui concerne une exposition du récepteur (5).

12. Dispositif selon l'une des revendications 5 à 7, **caractérisé en ce que** deux récepteurs au moins sont disposés, dans la direction de commutation du moyen de commutation, en étant distancés l'un de l'autre d'au moins un pas de commutation, et **en ce que** le diaphragme présente une zone d'ombre en raison de laquelle, lors d'un passage du moyen de commutation d'une position de commutation à une position de commutation voisine, uniquement l'état d'un seul récepteur est respectivement modifié.

13. Dispositif selon l'une des revendications 1 à 12, **caractérisé en ce que** le moyen de commutation peut être déplacé dans deux ou plusieurs directions et présente, dans chacune de ces directions, un circuit de réception, respectivement un circuit de sources lumineuses pour la réalisation des positions de commutation, et que le diaphragme présente une surface courbe au moins dans la zone d'ombre, dont le centre de courbure est situé au point d'intersection des axes de rotation.

14. Dispositif selon l'une des revendications 1 à 13, **caractérisé en ce que** le moyen de commutation est monté en rotation autour d'un ou de plusieurs axes, que la source lumineuse, respectivement le récepteur se trouve dans la région du point d'intersection des axes de rotation, et que le diaphragme présente une surface courbe, au moins dans la zone d'ombre, dont le centre de courbure est situé au point d'intersection des axes de rotation.

15. Dispositif selon l'une des revendications 1 à 14, **caractérisé en ce que,** comme source lumineuse ou sources lumineuses, on utilise des sources lumineuse émettant de la lumière IR, et que le récepteur, respectivement les récepteurs sont sensibles aux IR et comprennent un filtre perméable à la lumière IR.

16. Dispositif selon l'une des revendications 1 à 15, **caractérisé en ce qu'**à chaque circuit de réception est associé un circuit de décodage binaire pour générer directement un signal de sortie numérique.

17. Dispositif selon l'une des revendications 1 à 16, **caractérisé en ce que** le récepteur utilisé est un réseau de capteurs, qui est composé de nombreux récepteurs photoélectriques, individuels, tel qu'un détecteur de caméra.
